# EUROPEAN PATENT APPLICATION

(11) **EP 4 398 699 A1**
(43) Date of publication of application: **10.07.2024**
(21) Application number: 22864644.4
(22) Date of filing: 31.08.2022
(51) Int. Cl.: H10N 10/17, H02N 11/00, H10N 10/01

(54) **HEAT-UTILIZING POWER GENERATION MODULE AND MANUFACTURING METHOD THEREFOR**

(30) Priority: 03.09.2021 JP 2021143914
(71) Applicant: Sanoh Industrial Co., Ltd., Shibuya-ku Tokyo 150-0002 (JP)
(72) Inventor: MEI, Biao, Koga-shi, Ibaraki 306-0041 (JP); WANG, Ye, Koga-shi, Ibaraki 306-0041 (JP); AHAREN, Tomoko, Koga-shi, Ibaraki 306-0041 (JP)
(74) Representative: Grünecker Patent- und Rechtsanwälte PartG mbB
(86) International application number: PCT/JP2022/032826
(87) International publication number: WO 2023/033062

(57) **Abstract**

A thermoelectric module comprises a thermoelectric unit including a first conductive layer having a first main face and a second main face and including a metal, a thermoelectric conversion layer including an electron thermal excitation layer and an electron transport layer and located on the first main face, an organic electrolyte layer located on the thermoelectric conversion layer, and a second conductive layer located on the second main face, wherein the electron transport layer is located between the first main face and the electron thermal excitation layer.

## Description

### Technical Field

The present disclosure relates to a thermoelectric module and a method of manufacturing the same.

### Background Art

A method using the Seebeck effect is an example of thermoelectric power generation using geothermal heat, exhaust heat of a factory, or the like. A thermoelectric power generation element disclosed in the following Patent Literature 1 is an example of thermoelectric power generation that does not use the Seebeck effect. Patent Literature 1 below discloses that thermal energy is converted into electrical energy by combining an electrolyte and a thermoelectric conversion material that generates thermally excited electrons and holes. By using such the thermoelectric element as a power source for electronic components, stable power can be supplied to the electronic components even under a high-temperature condition (for example, 50°C or higher) in which general batteries are likely to deteriorate, for example.

### Citation List

### Patent Literature

[Patent Literature 1] International Publication No. WO 2017/038988
[Patent Literature 2] Japanese Patent Application Publication No. 2020-108315

### Summary of Invention

### Technical Problem

In a case where electrolytes included in a thermoelectric element (thermoelectric module) as described above include an organic material, the electrolytes may be easily deteriorated during manufacturing of the thermoelectric element. When such deterioration occurs, initial performance of the thermoelectric element also deteriorates.

An object of one aspect of the present disclosure is to provide a thermoelectric module capable of suppressing deterioration of initial performance, and a method of manufacturing the same.

### Solution to Problem

A thermoelectric module according to an aspect of the present disclosure comprises a thermoelectric unit including a first conductive layer including a first main face and a second main face and containing a metal, a thermoelectric conversion layer located on the first main face and including an electron thermal excitation layer and an electron transport layer , an organic electrolyte layer located on the thermoelectric conversion layer, and a second conductive layer located on the second main face, wherein the electron transport layer is located between the first main face and the electron thermal excitation layer.

The thermoelectric unit included in the thermoelectric module has the above-described configuration. Thus, the thermoelectric unit can be manufactured without forming any layer on the organic electrolyte layer. Therefore, the organic electrolyte layer is less likely to deteriorate during the manufacturing of the thermoelectric unit. Therefore, according to one aspect of the present disclosure, it is possible to provide a thermoelectric module capable of suppressing deterioration of initial performance.

The second conductive layer may include a conductive organic material. In this case, the thermoelectric unit can be manufactured without forming any layer on the second conductive layer including the conductive organic material. Therefore, the second conductive layer is less likely to deteriorate during the manufacturing of the thermoelectric unit. In addition, the contact resistance between the second conductive layer and the organic electrolyte layer can be suppressed.

The thermoelectric module may include a plurality of thermoelectric units, and the organic electrolyte layer, the thermoelectric conversion layer, the first conductive layer, and the second conductive layer may be stacked in order, in each of the plurality of thermoelectric units. In this case, for example, the electromotive force of the thermoelectric module and the like can be improved by connecting the thermoelectric units in series.

The electron transport layer may include an n-type semiconductor, the electron thermal excitation layer may include an i-type semiconductor, and the organic electrolyte layer may include a p-type semiconductor. In this case, since electrons and holes in the thermoelectric unit can be rectified, electrical current easily flows through the thermoelectric module.

The organic electrolyte layer may have flexibility. In this case, for example, when the thermoelectric module is disposed on a curved surface or the like, damage on the organic electrolyte layer can be suppressed.

Each of the first conductive layer, the thermoelectric conversion layer, the organic electrolyte layer and the second conductive layer may have flexibility. In this case, the thermoelectric module can be suitably disposed on a curved surface corresponding to the surface of the pipe, for example.

When not heated, the thermoelectric unit may have a two part structure of a conductive part and an insulating part, the conductor having the first conductive layer and the second conductive layer, and the insulator having the thermoelectric conversion layer and the organic electrolyte layer. In this case, a short circuit in the thermoelectric unit can be prevented.

The thermoelectric module may further include a first current collector including a conductive layer including a conductive organic material and located at one end in a stacking direction of the first conductive layer, the thermoelectric conversion layer, the organic electrolyte layer and the second conductive layer, and a second current collector including another conductive layer including a metal located at the other end in the stacking direction. In this case, the number of components of the thermoelectric module can be reduced.

The thermoelectric module may further include a first current collector located at one end in a stacking direction of the first conductive layer, the thermoelectric conversion layer, the organic electrolyte layer and the second conductive layer, and a second current collector located at the other end in the stacking direction, wherein the first current collector may include the first conductive layer, the second conductive layer and a third conductive layer including a metal, and the second conductive layer may be located between the first conductive layer and the third conductive layer in the stacking direction. In this case, the heat transfer to the thermoelectric unit via the first current collector can be improved.

A method of manufacturing a thermoelectric module according to another aspect of the present disclosure includes a first step of forming an electron transport layer on a first main face of a first conductive layer including a metal, a second step of forming an electron thermal excitation layer on the electron transport layer, a third step of forming a second conductive layer on a second main face of the first conductive layer, and a fourth step of forming an organic electrolyte layer on the electron thermal excitation layer.

According to this manufacturing method, no layer is formed on the organic electrolyte layer until the fourth step. Therefore, the organic electrolyte layer is less likely to deteriorate during the manufacturing of the thermoelectric unit. Therefore, according to another aspect of the present disclosure, it is possible to provide a method of manufacturing a thermoelectric module capable of suppressing deterioration of initial performance.

In the third step, the second conductive layer including a conductive organic material may be formed. In this case, no layer is formed on the second conductive layer until the fourth step. Therefore, the second conductive layer is less likely to deteriorate during the manufacturing of the thermoelectric unit.

The manufacturing method may further include stacking thermoelectric units each other, each of the thermoelectric units including the first conductive layer, the electron transport layer, the electron thermal excitation layer, the organic electrolyte layer and the second conductive layer. In this case, for example, the electromotive force of the thermoelectric module and the like can be improved by connecting the thermoelectric units in series.

In the third step, heat drying may be performed, and in the fourth step following the third step, vacuum drying may be performed. In this case, the organic electrolyte layer can be formed without heating. Therefore, the organic electrolyte layer can easily include a material that is easily thermally denatured. Accordingly, both performance improvement of the organic electrolyte layer and initial performance deterioration can be achieved. In addition, the film quality of the second conductive layer can be improved by heating.

The manufacturing method may further include forming a first current collector, wherein the first current collector may include the first conductive layer, the second conductive layer and a third conductive layer including a metal, and the second conductive layer may be located between the first conductive layer and the third conductive layer in a stacking direction of the first conductive layer and the second conductive layer.

The manufacturing method may further include bringing a second current collector into contact with the organic electrolyte layer, wherein the second current collector may include an organic conductive layer in contact with the organic electrolyte layer. In this case, contact resistance between the second current collector and the organic electrolyte layer may be suppressed.

### Advantageous Effects of Invention

According to an aspect of the present disclosure, it is possible to provide a thermoelectric module capable of suppressing deterioration of initial performance and a method of manufacturing the same.

### Brief Description of Drawings

FIG. 1 is a schematic cross-sectional view illustrating a thermoelectric module according to a first embodiment.
FIG. 2 is a schematic cross-sectional view illustrating a thermoelectric unit.
(a) to (d) of FIG. 3 are views for describing a method of manufacturing a thermoelectric module according to a first embodiment.
(a) and (b) of FIG. 4 are views for describing a method of manufacturing a thermoelectric module according to a first embodiment.
(a) of FIG. 5 is a schematic cross-sectional view illustrating a second thermoelectric unit used in a thermoelectric module according to a second embodiment, and (b) of FIG. 5 is a schematic cross-sectional view illustrating the thermoelectric module according to the second embodiment.

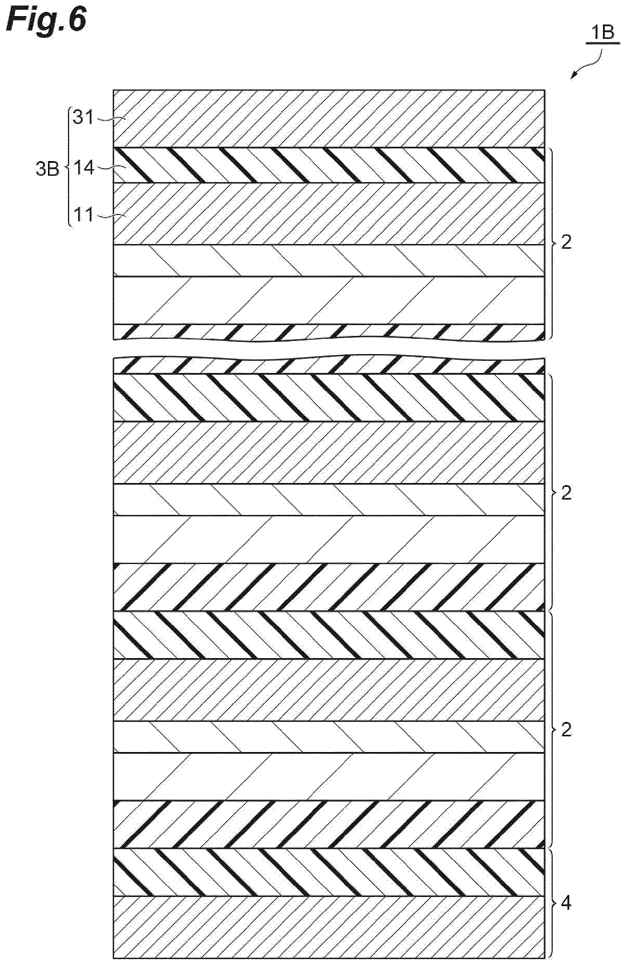

FIG. 6 is a schematic cross-sectional view illustrating a thermoelectric module according to a third embodiment.

### Description of Embodiments

Hereinafter, embodiments of the present disclosure will be described in detail with reference to the accompanying drawings. In the following description, identical elements or elements having identical functions are denoted by identical reference numerals, and redundant description is omitted.

### (First Embodiment)

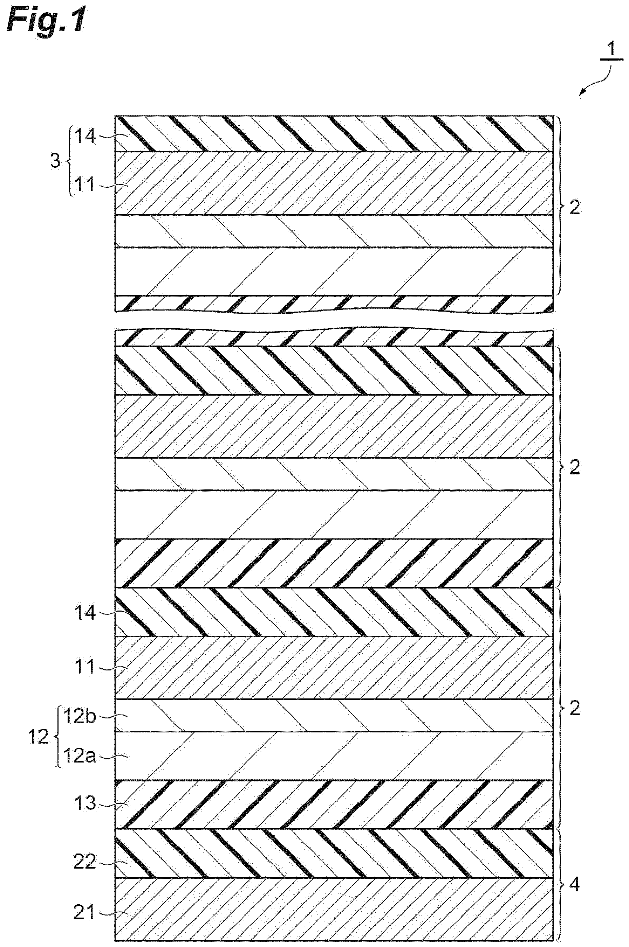

First, the configuration of a thermoelectric module according to a first embodiment will be described with reference to FIG. 1. FIG. 1 is a schematic cross-sectional view illustrating a thermoelectric module according to a first embodiment. A thermoelectric module 1 shown in FIG. 1 is an assembly of members having a function of generating electric power by being supplied with heat from the outside. The member having a function of generating electric power by being supplied with heat from the outside is, for example, a thermoelectric generator that converts thermal energy into electric energy. The thermoelectric module 1 is disposed on piping for a thermal fluid such as a hot spring or steam, or on a device such as a solar cell. In these cases, the thermoelectric module 1 is used as a power source for a sensor or the like for the above-described device. Alternatively, the thermoelectric module 1 may be attached to an exhaust heat unit of an air conditioner, a combustion device, or the like, or may be used as a power source for a wearable device. Since the thermoelectric module 1 has flexibility, the thermoelectric module 1 can be favorably disposed on a curved surface which is a surface of the pipe, for example. The shape of the thermoelectric module 1 is not particularly limited. The shape of the thermoelectric module 1 in planar view may be, for example, a polygonal shape such as a rectangular shape, a circular shape, or an elliptical shape.

The thermoelectric module 1 includes a plurality of thermoelectric units 2 and a pair of current collectors 3 and 4. The plurality of thermoelectric units 2 and the pair of current collectors 3 and 4 overlap each other along a predetermined direction. The plurality of thermoelectric units 2 are located between the pair of current collectors 3 and 4. Hereinafter, the predetermined direction is simply referred to as a "stacking direction". In the present specification, "identical" is a concept including not only "completely identical" but also "substantially identical".

Each of the plurality of thermoelectric units 2 is a thermoelectric generator having an identical shape, and generates thermally excited electrons and holes by being supplied with heat from the outside. The generation of thermally excited electrons and holes by the thermoelectric unit 2 is performed, for example, at 25°C or more and 300°C or less. From the viewpoint of generating a sufficient number of thermally excited electrons and holes, the thermoelectric unit 2 may be heated to, for example, 50°C or higher when the thermoelectric module 1 is used. From the viewpoint of satisfactorily preventing the deterioration of the thermoelectric unit 2 or the like, the thermoelectric unit 2 is heated to, for example, 200°C or less when the thermoelectric module 1 is used. The temperature at which a sufficient number of thermally excited electrons are generated is, for example, "a temperature at which the thermally excited electron density of the thermoelectric unit 2 is 10¹⁵/cm³ or more". In the first embodiment, the electric power generation mechanism of the thermoelectric module 1 and the thermoelectric unit 2 is the same as the electric power generation mechanism described in, for example, Japanese Patent Application Publication No. 2020-108315 or the like.

In the first embodiment, the plurality of thermoelectric units 2 overlap each other along the stacking direction and are connected in series to each other. The number of the thermoelectric units 2 varies depending on the performance required for the thermoelectric module 1.

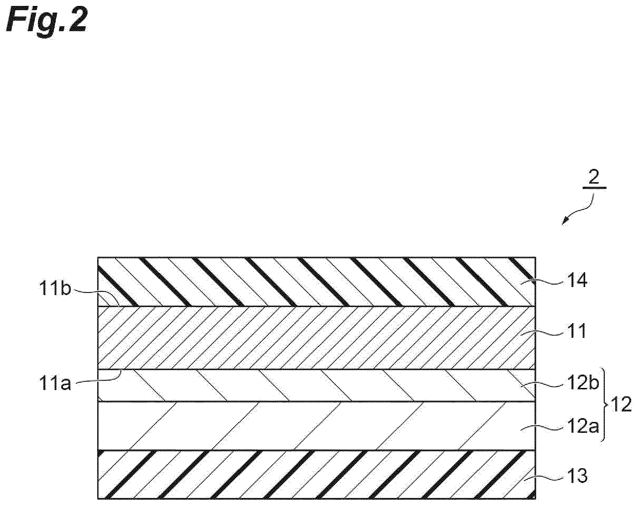

FIG. 2 is a schematic cross-sectional view illustrating a thermoelectric unit. As shown in FIG. 2, the thermoelectric unit 2 is a laminated body including a first conductive layer 11, a thermoelectric conversion layer 12, an electrolyte layer 13 and a second conductive layer 14. The first conductive layer 11, the thermoelectric conversion layer 12, the electrolyte layer 13 and the second conductive layer 14 overlap each other in the stacking direction. Each of the first conductive layer 11, the thermoelectric conversion layer 12, the electrolyte layer 13 and the second conductive layer 14 may have flexibility. In the first embodiment, the electrolyte layer 13, the thermoelectric conversion layer 12, the first conductive layer 11 and the second conductive layer 14 are stacked in order in the stacking direction. In each thermoelectric unit 2, the stacking order of the electron thermal excitation layer 12a, the electron transport layer 12b and the electrolyte layer 13 is the same.

The first conductive layer 11 is a conductor including a metal in the thermoelectric unit 2, and is, for example, a metal plate, an alloy plate, or a composite plate thereof. The metal plate is, for example, an aluminum foil, a nickel foil, or the like. The alloy plate is, for example, an aluminum alloy foil, a nickel alloy foil, or the like. The first conductive layer 11 has a first main face 11a and a second main face 11b. Each of the first main face 11a and the second main face 11b is a surface intersecting with the stacking direction. The heat conductivity of the first conductive layer 11 is, for example, 10W/m· K or more.

The thermoelectric conversion layer 12 is a layer that converts heat into electricity and is located on the first main face 11a. The thermoelectric conversion layer 12 has an electron thermal excitation layer 12a and an electron transport layer 12b that overlap each other in the stacking direction. In each thermoelectric unit 2, the stacking order of the electron thermal excitation layer 12a, the electron transport layer 12b and the electrolyte layer 13 is the same. In the first embodiment, the electron transport layer 12b is located on the first main face 11a, the electron thermal excitation layer 12a is located on the electron transport layer 12b and the electrolyte layer 13 is located on the electron thermal excitation layer 12a (i.e., on the thermoelectric conversion layer 12). Therefore, in the first embodiment, the electrolyte layer 13, the electron thermal excitation layer 12a, the electron transport layer 12b, the first conductive layer 11 and the second conductive layer 14 are stacked in order in the stacking direction.

The electron thermal excitation layer 12a is a layer that generates thermally excited electrons and holes in the thermoelectric unit 2, and is in contact with the electrolyte layer 13. The electron thermal excitation layer 12a includes a thermoelectric conversion material. The thermoelectric conversion material is a material in which excited electrons increase under a high-temperature condition, and is, a semiconductor material of a semiconductor such as a metal semiconductor (Si, Ge), a tellurium compound semiconductor, a silicon germanium (Si-Ge) compound semiconductor, a silicide compound semiconductor, a skutterudite compound semiconductor, a clathrate compound semiconductor, a Heusler compound semiconductor, a half-Heusler compound semiconductor, a metal oxide semiconductor, a metal sulfide semiconductor, an organic semiconductor, or the like. Examples of the metal oxide semiconductor include titanium dioxide (TiO₂), zinc oxide (ZnO), aluminum-doped zinc oxide (AZO), tin dioxide (SnO₂), and indium oxide (In₂O₃). Examples of the metal sulfide semiconductor include zinc sulfide (ZnS), silver sulfide (Ag₂S), and cadmium sulfide (CdS). From the viewpoint of generating sufficient thermally excited electrons at a relatively low temperature, the thermoelectric conversion material may be germanium (Ge). From the viewpoint of the flexibility of the electron thermal excitation layer 12a, the thermoelectric conversion material may be a metal oxide semiconductor, a metal sulfide semiconductor, or the like. When the electron thermal excitation layer 12a includes a semiconductor material, the semiconductor material includes, for example, an i-type semiconductor. In the first embodiment, silver sulfide that can function as an i-type semiconductor is included in the electron thermal excitation layer 12a.

The electron thermal excitation layer 12a may include a plurality of thermoelectric conversion materials. The electron thermal excitation layer 12a may include a material other than the thermoelectric conversion material. For example, the electron thermal excitation layer 12a may include a binder that binds the thermoelectric conversion material, a sintering aid that assists in forming the thermoelectric conversion material, and the like. The electron thermal excitation layer 12a may be formed by a dry method or a wet method. The electron thermal excitation layer 12a is formed by, for example, an ink jet method, a drop casting method, a squeegee method, a screen printing method, a spark plasma sintering method, a compression molding method, a sputtering method, a vacuum evaporation method, a chemical vapor deposition method (CVD method), a spin coating method, or the like.

The electron transport layer 12b is a layer located on the first main face 11a. The electron transport layer 12b transports thermally excited electrons generated in the electron thermal excitation layer 12a to the outside of the electron thermal excitation layer 12a. The electron transport layer 12b is located between the first main face 11a and the electron thermal excitation layer 12a in the stacking direction, and is located on the opposite side of the electrolyte layer 13 via the electron thermal excitation layer 12a in the stacking direction. Therefore, in the thermoelectric unit 2, as described above, the electron transport layer 12b, the electron thermal excitation layer 12a and the electrolyte layer 13 are stacked in order in the stacking direction. The electron transport layer 12b includes an electron transport material. The electron transport material is a material whose conduction band potential is the same as or more positive than that of the thermoelectric conversion material. The difference between the conduction band potential of the electron-transport material and the conduction band potential of the thermoelectric conversion material is, for example, 0.01V or more and 0.1V or less. The electron transport material is, for example, a semiconductor material, an electron transporting organic material, or the like. The electron transport layer 12b may be formed by a dry method or a wet method. The electron transport layer 12b is formed by, for example, a squeegee method, a screen printing method, a spark plasma sintering method, a compression molding method, a sputtering method, a vacuum evaporation method, a CVD method, an ink jet method, a spin coating method, or the like.

The semiconductor material used for the electron-transport material and the semiconductor material contained in the electron thermal excitation layer 12a may be identical or different. When the electron transport material is a semiconductor material, the semiconductor material may be an n-type semiconductor. Examples of the electron transporting organic material include an n-type conductive macromolecule, an n-type low-molecular organic semiconductor, and a π-electron conjugated compound. The electron transport layer 12b may include a plurality of electron transport materials. The electron transport layer 12b may contain a material other than the electron transport material. For example, the electron transport layer 12b may include a binder to bind the electron transport material, a sintering aid to aids in shaping the electron transport material, and the like. In the first embodiment, titanium dioxide that can function as an n-type semiconductor is included in the electron transport layer 12b.

The electrolyte layer 13 is a layer including an electrolyte in which charge transport ion pairs can move at a temperature at which a sufficient number of thermally excited electrons are generated in the thermoelectric unit 2. The movement of the charge transport ion pair in the electrolyte layer 13 causes electrical current to flow through the electrolyte layer 13. The "charge transport ion pair" is a stable pair of ions having different valences, and is, for example, a metal ion. When one ion is oxidized or reduced, it becomes the other ion, whereby electrons and holes can be transferred. The oxidation-reduction potential of the charge transport ion pair in the electrolyte layer 13 is more negative than the valence band potential of the thermoelectric conversion material contained in the electron thermal excitation layer 12a. Therefore, at the interface between the electron thermal excitation layer 12a and the electrolyte layer 13, one ion of the charge transport ion pairs which is easily oxidized is oxidized and becomes the other ion. The electrolyte layer 13 may include ions other than charge transport ion pairs. The electrolyte layer 13 may be formed by a dry method or a wet method. The electrolyte layer 13 can be formed by, for example, a squeegee method, a screen printing method, a sputtering method, a vacuum deposition method, a CVD method, a sol-gel method, or a spin coating method.

The electrolyte contained in the electrolyte layer 13 is not particularly limited. The electrolyte may be, for example, a liquid electrolyte, a solid electrolyte, or a gel electrolyte. In the first embodiment, the electrolyte layer 13 includes a solid electrolyte. The solid electrolyte is, for example, a substance that is physically and chemically stable at the above-described temperature, and may include polyvalent ions. Examples of the solid electrolyte include a sodium ion conductor, a copper ion conductor, an iron ion conductor, a lithium ion conductor, a silver ion conductor, a hydrogen ion conductor, a strontium ion conductor, an aluminum ion conductor, a fluorine ion conductor, a chlorine ion conductor, and an oxide ion conductor. The solid electrolyte may be, for example, polyethylene glycol (PEG) having a molecular weight of 600,000 or less, or a derivative thereof. When the solid electrolyte is PEG, a polyvalent ion source such as a copper ion, an iron ion or the like may be included in the electrolyte layer 13. Alkali metal ions may be included in the electrolyte layer 13 from the viewpoint of improving the lifetime or the like. The molecular weight of PEG corresponds to a weight average molecular weight measured by gel permeation chromatography in terms of polystyrene. The electrolyte layer 13 may be a hole transport semiconductor. In reduction, the electrolyte layer 13 may include a p-type semiconductor. The electrolyte layer 13 may include a separator (insulating layer) having insulating properties.

In the first embodiment, the electrolyte layer 13 is an organic electrolyte layer having flexibility. The organic electrolyte layer is a layer including at least an organic electrolyte. The organic electrolyte layer is, for example, an electrolyte layer having one or more organic materials as a main composition. The organic electrolyte includes at least one of a low- molecular organic compound and a macromolecular organic compound. The organic electrolyte may include an organic material different from the electrolyte. The composition of the electrolyte layer 13 is determined according to, for example, the performance of the thermoelectric module 1 and the like. The organic electrolyte layer may include an inorganic material. For example, the electrolyte layer 13 may include an organic material or an inorganic material functioning as a binder that binds the electrolyte, a sintering aid that assists in forming the electrolyte, and the like. The conductive organic material is a conductive polymer (for example, PEG), N-methylpyrrolidone (NMP), acetonitrile, or the like. The conductive polymer other than PEG may also include a polyvalent ion source, such as a copper ion, an iron ion, or the like. Examples of the inorganic material include silicon dioxide (SiO₂), titanium dioxide, and aluminum oxide (AlOx). An organic compound having a molecular weight of 10,000 or more is referred to as a macromolecular organic compound.

The second conductive layer 14 is a conductor different from the first conductive layer 11 in the thermoelectric module 1, and is located on the second main face 11b of the first conductive layer 11. In the first embodiment, for example, the conductive organic material described above is included. The second conductive layer 14 may be formed by a dry method or a wet method. The second conductive layer 14 can be formed by, for example, a squeegee method, a screen printing method, a sputtering method, a vacuum deposition method, a CVD method, a sol-gel method, or a spin coating method. The second conductive layer 14 has a heat conductivity of, for example, 0.2W/m· K or more.

The current collector 3 is an electrode (first current collector) that functions as one of a positive electrode and a negative electrode in the thermoelectric module 1, and is located at one end of the thermoelectric module 1 in the stacking direction. The current collector 4 is an electrode (second current collector) that functions as the other of the positive electrode and the negative electrode in the thermoelectric module 1, and is located at the other end of the thermoelectric module 1 in the stacking direction. Each of the current collectors 3 and 4 is, for example, a conductive plate having a single-layer structure or a layered structure. At least one of the current collectors 3 and 4 may include a portion of the thermoelectric unit 2. In the first embodiment, the current collector 3 includes a part of the thermoelectric unit 2. The plate including a metal in the conductive plate may have a same configuration as that of the first conductive layer 11, or may be a metal plate having a configuration different from that of the first conductive layer 11. The plate including a conductive organic material in the conductive plate may have, for example, a same configuration as that of the second conductive layer 14, or may be a conductive plate having a configuration different from that of the second conductive layer 14.

In the first embodiment, the current collector 3 includes the first conductive layer 11 and the second conductive layer 14 included in the thermoelectric unit 2. The first conductive layer 11 of the current collector 3 is located between the second conductive layer 14 included in the current collector 3 and the thermoelectric conversion layer 12 in the stacking direction. Accordingly, the second conductive layer 14 (conductive layer) including a conductive organic material is located at one end of the thermoelectric module 1 in the stacking direction. On the other hand, the current collector 4 includes a conductive layer 21 including a metal and a conductive layer 22 (organic conductive layer) including a conductive organic material. The conductive layer 22 of the current collector 4 is located between the thermoelectric unit 2 and the conductive layer 21 in the stacking direction. Therefore, the conductive layer 21 (another conductive layer) including a metal is located at the other end of the thermoelectric module 1 in the stacking direction. From the viewpoint of giving the best performance of the thermoelectric module 1 favorably, at least one of the current collectors 3 and 4 may exhibit high thermal conductivity. Since a temperature difference is unnecessary in the thermoelectric module 1, it is desirable that both of the current collectors 3 and 4 exhibit high thermal conductivity. For example, the heat conductivity of at least one of the current collectors 3 and 4 may be 10W/m· K or more.

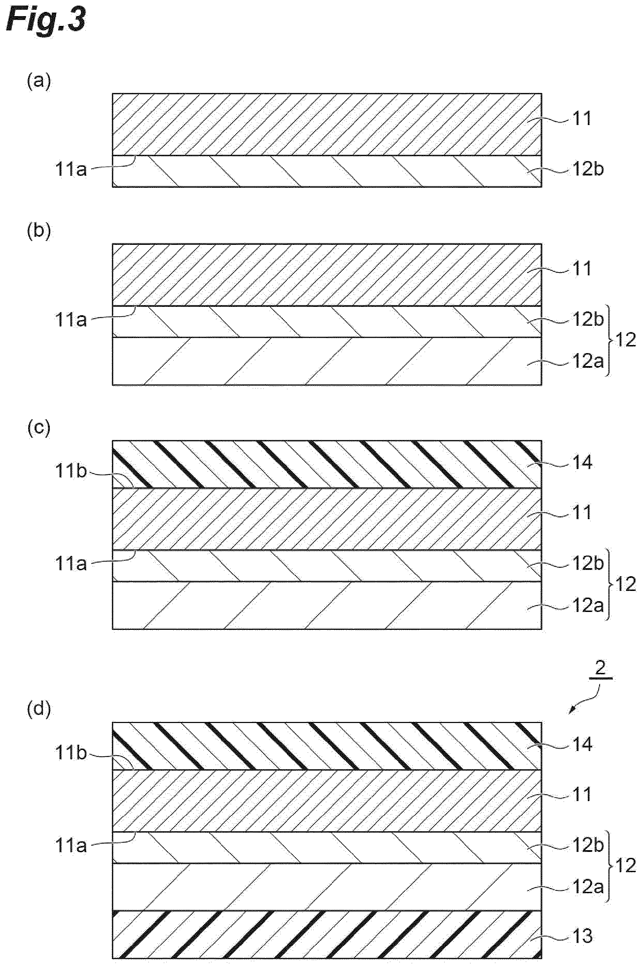

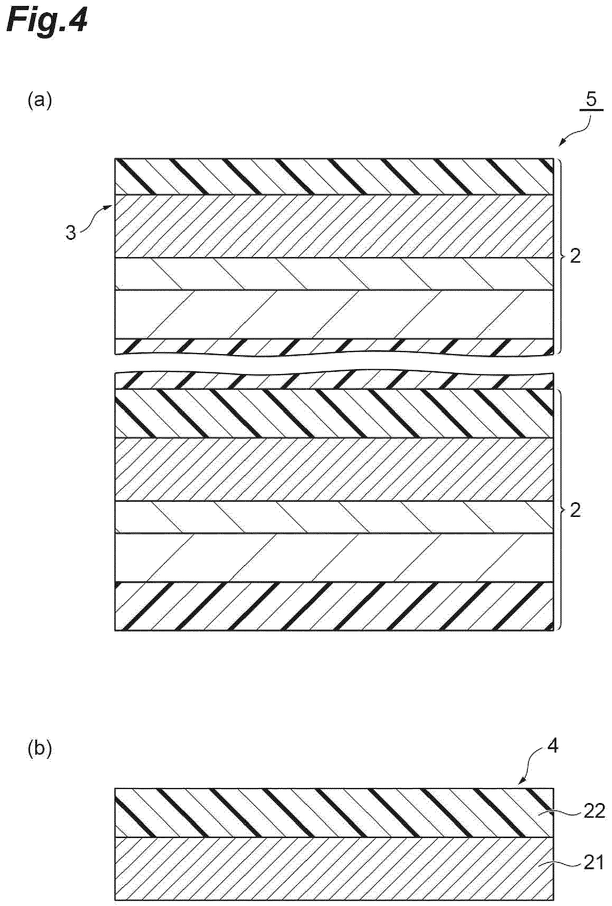

Next, an example of a method of manufacturing the thermoelectric module 1 will be described with reference to (a) to (d) of FIG. 3 and (a) and (b) of FIG. 4 . Each of (a) to (d) of FIG. 3 and (a) and (b) of FIG. 4 is a view for describing a method of manufacturing a thermoelectric module according to a first embodiment.

First, as shown in (a) of FIG. 3, an electron transport layer 12b is formed on a first main face 11a of a first conductive layer 11 (first step). In the first step, the electron transport layer 12b is formed on the first main face 11a by a dry method or a wet method. In the first embodiment, the electron transport layer 12b is formed by a wet method. In this case, since the electron transport layer 12b can be formed in the atmosphere, the manufacturing cost can be reduced. In the first embodiment, for example, the electron transport layer 12b is formed by applying a liquid including an electron transport material on the first main face 11a and then drying the liquid. The drying may be natural drying, vacuum drying, or well-known heating drying. In a case where, for example, a spin coating method is performed as the wet method, the liquid is dropped on the first main face 11a of the first conductive layer 11 fixed to a spin coater, and then the first conductive layer 11 is rotated. Thus, the first main face 11a is covered with the liquid. Then, the liquid is dried. The liquid is, for example, water or a known organic solvent having low reactivity with the electron transport material.

Next, as shown in (b) of FIG. 3, after the first step, an electron thermal excitation layer 12a is formed on the electron transport layer 12b (second step). In the second step, for example, the electron thermal excitation layer 12a is formed on the electron transport layer 12b by a dry method or a wet method. Accordingly, the thermoelectric conversion layer 12 including the electron thermal excitation layer 12a and the electron transport layer 12b is formed. In the first embodiment, the electron thermal excitation layer 12a is formed by a wet method. In this case, for example, the electron thermal excitation layer 12a is formed by applying a liquid containing a thermoelectric conversion material on the electron transport layer 12b and then drying the liquid. The drying may be natural drying, vacuum drying, or well-known heating drying. For example, when the spin coating method is performed as the wet method, first, the first conductive layer 11 on which the electron transport layer 12b will be formed is fixed to the spin coater. Subsequently, the liquid is dropped on the electron transport layer 12b, and then the first conductive layer 11 is rotated. Thus, the electron transport layer 12b is covered with the liquid. Then, the liquid is dried.

In the second step, the thermoelectric conversion material may not be directly provided on the electron transport layer 12b. For example, first, a precursor of the thermoelectric conversion material is formed on the electron transport layer 12b. For example, when the thermoelectric conversion material is silver sulfide, silver particles are formed on the electron transport layer 12b as a precursor. This precursor is dispersed in a temporary layer provided on the electron transport layer 12b, for example. The temporary layer corresponds to, for example, a dried product of a liquid including a precursor. Subsequently, a thermoelectric conversion material based on the precursor is formed to form an electron thermal excitation layer 12a. For example, the thermoelectric conversion material is formed by immersing the electron transport layer 12b on which the temporary layer has been formed in a solution and causing the precursor to chemically react. At this time, the first conductive layer 11 may also be immersed in the solution. For example, when the thermoelectric conversion material is silver sulfide, the electron transport layer 12b on which the temporary layer has been formed is caused to immersing in a solution containing sulfur. Then, the temporary layer and the like are dried to form an electron thermal excitation layer 12a.

Next, as shown in (c) of FIG. 3, after the second step, a second conductive layer 14 is formed on the second main face 11b of the first conductive layer 11 (third step). In the third step, the second conductive layer 14 is formed on the second main face 11b of the first conductive layer 11 on which the thermoelectric conversion layer 12 has been formed. The second conductive layer 14 is formed on the second main face 11b by, for example, a dry method or a wet method. In the first embodiment, the second conductive layer 14 is formed by a wet method. In this case, for example, the second conductive layer 14 is formed by applying a liquid including a conductive organic material such as a conductive polymer on the second main face 11b, and then drying the liquid. The drying may be natural drying, vacuum drying, or well-known heating drying. From the viewpoint of improving the film quality of the second conductive layer 14 and the like, heat drying may be performed. The liquid is, for example, water or a known organic solvent having low reactivity with a conductive organic material.

Next, as shown in (d) of FIG. 3, after the third step, an electrolyte layer 13 is formed on the electron thermal excitation layer 12a of the thermoelectric conversion layer 12 (fourth step). In the fourth step, for example, the electrolyte layer 13 is formed on the electron thermal excitation layer 12a by a dry method or a wet method. In the first embodiment, the electrolyte layer 13 is formed by a wet method. In this case, for example, the electrolyte layer 13 is formed by applying a liquid including an organic electrolyte on the electron thermal excitation layer 12a, and then drying the liquid. The drying may be natural drying or vacuum drying. On the other hand, from the viewpoint of prevention of denaturation of the organic electrolyte and the like, the drying does not include heating drying (more specifically, heating drying at 200°C or higher). The liquid is, for example, water or a known organic solvent having low reactivity with the organic electrolyte. The thermoelectric unit 2 is formed by sequentially performing the first step to the fourth step. The thermoelectric unit 2 has a two part structure of a conductive part composed of a first conductive layer 11 and a second conductive layer 14 and an insulating part composed of an electron thermal excitation layer 12a, an electron transport layer 12b, and an electrolyte layer 13 when not heated.

Next, as shown in (a) of FIG. 4, after the fourth step, each the thermoelectric unit 2 including the first conductive layer 11, the electron transport layer 12b, the electron thermal excitation layer 12a, the electrolyte layer 13 and the second conductive layer 14 is stacked each other(fifth step). In the fifth step, the plurality of thermoelectric units 2 formed through the first to fourth steps are stacked along the stacking direction. Specifically, in two adjacent thermoelectric units 2, the second conductive layer 14 of one thermoelectric unit 2 and the electrolyte layer 13 of the other thermoelectric unit 2 are brought into contact with each other. Thus, a laminated body 5 having a plurality of thermoelectric units 2 is formed.

Next, as shown in (b) of FIG. 4, a current collector 4 is prepared (sixth step). In the sixth step, the current collector 4 having the conductive layers 21 and 22 is prepared. The current collector 4 is formed by forming the conductive layer 22 on the conductive layer 21. The conductive layer 22 is formed on the conductive layer 21 by a dry method or a wet method, for example. In the first embodiment, the conductive layer 22 is formed by a wet method. In this case, for example, the conductive layer 22 is formed by the same method as that of the second conductive layer 14. The sixth step may be performed after the fifth step, may be performed before the first step, or may be performed during the execution of the first step to the fourth step described above.

Next, the laminated body 5 and the current collector 4 are stacked (seventh step). In the seventh step, the conductive layer 22 of the current collector 4 is brought into contact with the electrolyte layer 13 located at one end of the laminated body 5 in the stacking direction. Accordingly, contact between the electrolyte layer 13 and the conductive layer 21 (more specifically, metal) can be prevented. Through the first step to the seventh step described above, the thermoelectric module 1 shown in FIG. 1 is manufactured. The thermoelectric module 1 may be vacuum-sealed in a film or the like, for example.

The operation and effect of the thermoelectric module 1 formed by the manufacturing method according to the first embodiment described above will be described using a comparative example described below. The thermoelectric unit according to the comparative example has a layered structure in which a first conductive layer, an electron thermal excitation layer, an electron transport layer, an electrolyte layer and a second conductive layer are stacked in order. That is, the thermoelectric unit according to the comparative example has a three part structure including a first conductive part composed of a first conductive layer, an insulating part composed of an electron thermal excitation layer, an electron transport layer and an electrolyte layer, and a second conductive part composed of a second conductive layer when not heated. In the comparative example, the second conductive layer is directly formed on the electrolyte layer. For example, when the second conductive layer is formed by a sputtering method or the like, damage to the electrolyte layer due to ion irradiation or the like may occur. For example, when the second conductive layer is formed by an inkjet method or the like, damage may occur due to dissolution of the electrolyte layer. Accordingly, in the comparative example, the initial performance of the thermoelectric unit may be deteriorated due to damage of the electrolyte layer. In addition, a short circuit may occur in the thermoelectric unit due to damage of the electrolyte layer.

In contrast, according to the thermoelectric module 1 formed by the manufacturing method according to the first embodiment, no layer is formed on the electrolyte layer 13 from the first step until the fourth step. Therefore, even when the electrolyte layer 13 includes an organic electrolyte, the electrolyte layer 13 is less likely to deteriorate during the manufacture of the thermoelectric unit 2. Therefore, according to the first embodiment, it is possible to provide the thermoelectric module 1 capable of suppressing deterioration of initial performance. In addition, the thermoelectric unit 2 is formed in a two part structure of a conductive part composed of the first conductive layer 11 and the second conductive layer 14 and an insulating part composed of the electron thermal excitation layer 12a, the electron transport layer 12b and the electrolyte layer 13 when not heated. Therefore, a short circuit in the thermoelectric unit 2 can be prevented.

In the first embodiment, the second conductive layer 14 includes a conductive organic material. Therefore, the thermoelectric unit 2 can be manufactured without forming any layer on the second conductive layer 14 including a conductive organic material. Therefore, the second conductive layer 14 is also less likely to deteriorate during the manufacture of the thermoelectric unit 2. In addition, the contact resistance between the second conductive layer 14 and the electrolyte layer 13 can be suppressed.

In the first embodiment, the thermoelectric module 1 includes a plurality of thermoelectric units 2. In each of the plurality of thermoelectric units 2, the electrolyte layer 13, the electron thermal excitation layer 12a, the electron transport layer 12b, the first conductive layer 11 and the second conductive layer 14 are stacked in order in the stacking direction. Therefore, for example, by connecting the thermoelectric units 2 in series, the electromotive force of the thermoelectric module 1 and the like can be improved. Here, in the first embodiment, the electrolyte layer 13 is in contact with the second conductive layer 14 while being spaced apart from the first conductive layer 11. Therefore, in the thermoelectric module 1, the electrolyte layer 13 is not in direct contact with metal. Therefore, since the reaction between the substance included in the electrolyte layer 13 and metal can be prevented, the contact resistance between the adjacent thermoelectric units 2 can be reduced.

In the first embodiment, the electron transport layer 12b may include an n-type semiconductor, the electron thermal excitation layer 12a may include an i-type semiconductor, and the electrolyte layer 13 may include a p-type semiconductor. In this case, since electrons and holes in the thermoelectric unit 2 can be rectified, electrical current easily flows through the thermoelectric module 1.

In the first embodiment, the electrolyte layer 13 has flexibility. Therefore, for example, when the thermoelectric module 1 is disposed on a curved surface or the like, damage to the electrolyte layer 13 can be suppressed. In addition, in the first embodiment, each of the first conductive layer 11, the electron transport layer 12b, the electron thermal excitation layer 12a, the electrolyte layer 13 and the second conductive layer 14 has flexibility. Therefore, the thermoelectric module 1 can be suitably disposed on a curved surface corresponding to the surface of the pipe.

In the first embodiment, when not heated, the thermoelectric unit 2 may have a two part structure of a conductive part composed of the first conductive layer 11 and the second conductive layer 14 and an insulating part composed of the thermoelectric conversion layer 12 and the electrolyte layer 13. In this case, a short circuit in the thermoelectric unit 2 can be prevented.

In the first embodiment, in the third step (third process), the second conductive layer 14 including a conductive organic material is formed. Therefore, no layer is formed on the second conductive layer 14 until the fourth step. As a result, the second conductive layer 14 is less likely to deteriorate during manufacturing of the thermoelectric unit 2.

In the first embodiment, the method of manufacturing the thermoelectric module 1 includes a fifth step (fifth process) of stacking each the thermoelectric unit 2 including the first conductive layer 11, the electron transport layer 12b, the electron thermal excitation layer 12a, the electrolyte layer 13 and the second conductive layer 14. In this case, for example, by connecting the thermoelectric units 2 in series, the electromotive force of the thermoelectric module 1 and the like can be improved. In addition, since each the thermoelectric unit 2 is merely stacked each other, the electrolyte layer 13, the second conductive layer 14, and the like are less likely to deteriorate in the fifth step. Therefore, it is possible to provide the thermoelectric module 1 capable of favorably suppressing deterioration of initial performance.

In the first embodiment, heat drying may be performed in the third step, and vacuum drying may be performed in the fourth step following the third step. In this case, the electrolyte layer 13 can be formed without being heated. For this reason, a material that is easily thermally denatured can be easily included in the electrolyte layer 13. Therefore, the performance of the electrolyte layer 13 can be improved and the initial performance thereof can be deteriorated. In addition, the film quality of the second conductive layer 14 can be improved by heating.

### (Second Embodiment)

Hereinafter, a thermoelectric module according to a second embodiment will be described. In the description of the second embodiment, description overlapping with that of the first embodiment will be omitted, and the differences from the first embodiment will be described. That is, the description of the first embodiment may be appropriately used for the second embodiment within a technically possible range.

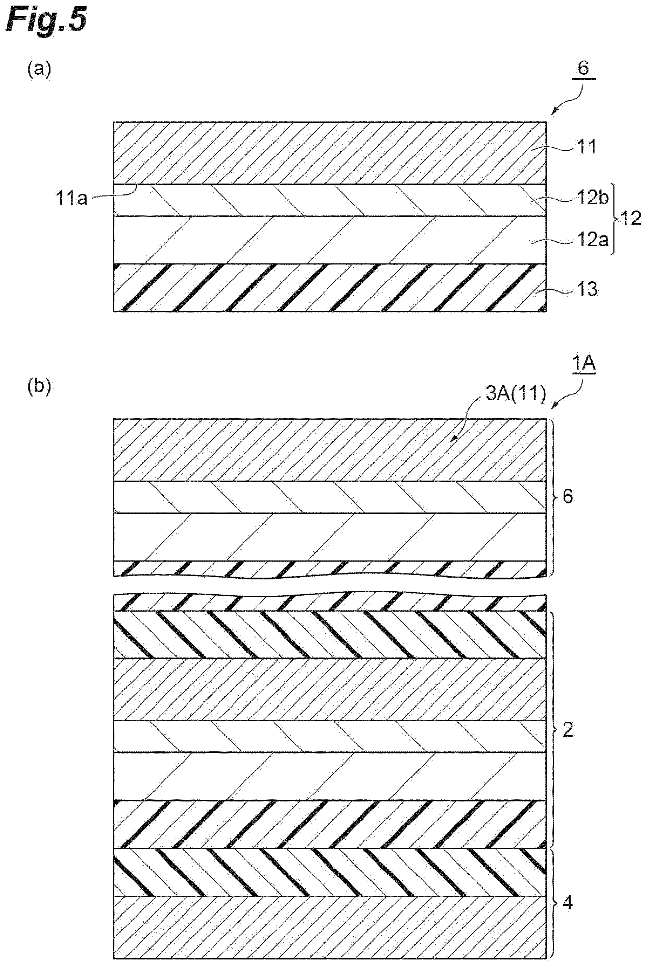

(a) of FIG. 5 is a schematic cross-sectional view illustrating a second thermoelectric unit used in a thermoelectric module according to a second embodiment. As shown in (a) of FIG. 5, a second thermoelectric unit 6 is different from the thermoelectric unit 2 in that it does not include the second conductive layer 14. In other words, the second thermoelectric unit 6 includes the first conductive layer 11, the thermoelectric conversion layer 12 and the electrolyte layer 13. The second thermoelectric unit 6 is formed, for example, by performing the first step, the second step, and the fourth step in the first embodiment.

(b) of FIG. 5 is a schematic cross-sectional view illustrating the thermoelectric module according to the second embodiment. As shown in (b) of FIG. 5, a thermoelectric module 1A includes a plurality of thermoelectric units 2, a current collector 3A, a current collector 4, and a second thermoelectric unit 6. In the stacking direction, the plurality of thermoelectric units 2 are located between the current collector 4 and the second thermoelectric unit 6. In the stacking direction, the current collector 4 is located at one end of the thermoelectric module 1A, and the second thermoelectric unit 6 is located at the other end of the thermoelectric module 1A. In the thermoelectric module 1A, the first conductive layer 11 of the second thermoelectric unit 6 corresponds to the current collector 3A.

Also in the thermoelectric module 1A according to the second embodiment described above, the same operation and effect as those of the first embodiment are exhibited. In addition, in the second embodiment, each of both ends of the thermoelectric module 1A is formed using a conductive layer including a metal. Therefore, as compared with the first embodiment, the thermal conductivity to the thermoelectric unit 2 and the second thermoelectric unit 6 can be improved.

### (Third Embodiment)

Hereinafter, a thermoelectric module according to a third embodiment will be described. In the description of the third embodiment, description overlapping with those of the first and second embodiments will be omitted, and the differences from the first and second embodiments will be described. That is, the description of the first and second embodiments may be appropriately used for the third embodiment within a technically possible range.

FIG. 6 is a schematic cross-sectional view illustrating a thermoelectric module according to a third embodiment. As shown in FIG. 6, the thermoelectric module 1B includes a plurality of thermoelectric units 2, a current collector 3B, and a current collector 4. The current collector 3B includes a conductive layer 31 (third conductive layer) including a metal, in addition to the first conductive layer 11 and the second conductive layer 14 included in the thermoelectric unit 2. The conductive layer 31 is a conductor including a metal same as the first conductive layer 11, and is, for example, a metal plate, an alloy plate, or a composite plate thereof. In the current collector 3B, the second conductive layer 14 is located between the first conductive layer 11 and the conductive layer 31 in the stacking direction. Therefore, the conductive layer 31 is located at one end of the thermoelectric module 1B in the stacking direction. The current collector 3B may be formed through, for example, bringing the conductive layer 31 into contact with the second conductive layer 14 after the fourth step. The current collector 3B may be formed after the third step, after the fifth step, or after the seventh step. From the viewpoint of preventing the deterioration of the second conductive layer 14, the current collector 3B may be formed in the fourth step or later.

Also in the thermoelectric module 1A according to the second embodiment described above, the same operation and effect as those of the second embodiment are exhibited.

The thermoelectric module and the manufacturing method thereof according to the present disclosure are not limited to the above-described embodiments and the like, and various other modifications are possible. For example, although the thermoelectric conversion layer includes the electron thermal excitation layer and the electron transport layer in the above-described embodiments, the present disclosure is not limited thereto. The thermoelectric conversion layer may include a layer other than the two layers described above.

Although the steps are numbered from the first step to the seventh step in the above embodiments, the order of these steps is not limited. For example, depending on the type of electrolyte included in the electrolyte layer, the third step may be performed after the fourth step.

### Reference Signs List

1, 1A, 1B: thermoelectric module
2: thermoelectric unit
3, 3A, 3B: current collector (first current collector)
4: current collector (second current collector)
5: laminated body
6: second thermoelectric unit
11: first conductive layer
11a: First main face
11b: second main face
12: thermoelectric conversion layer
12a: electron thermal excitation layer
12b: electron transport layer
13: electrolyte layer
14: second conductive layer
21: conductive layer (another conductive layer)
22: conductive layer (organic conductive layer)
31: conductive layer (third conductive layer).

## Claims

1. A thermoelectric module comprising:
a thermoelectric unit including:
a first conductive layer including a first main face and a second main face and containing a metal;
a thermoelectric conversion layer located on the first main face and including an electron thermal excitation layer and an electron transport layer;
an organic electrolyte layer located on the thermoelectric conversion layer; and
a second conductive layer located on the second main face,
wherein the electron transport layer is located between the first main face and the electron thermal excitation layer.

2. The thermoelectric module according to claim 1, wherein the second conductive layer includes a conductive organic material.

3. The thermoelectric module according to claim 1 or 2,
wherein the thermoelectric module comprises a plurality of thermoelectric units,
wherein in each of the plurality of thermoelectric units, the organic electrolyte layer, the thermoelectric conversion layer, the first conductive layer and the second conductive layer are stacked in order.

4. The thermoelectric module according to any one of claims 1 to 3,
wherein the electron transport layer includes an n-type semiconductor,
wherein the electron thermal excitation layer includes an i-type semiconductor, and
wherein the organic electrolyte layer includes a p-type semiconductor.

5. The thermoelectric module according to any one of claims 1 to 4,
wherein the organic electrolyte layer has flexibility.

6. The thermoelectric module according to any one of claims 1 to 5,
wherein each of the first conductive layer, the thermoelectric conversion layer, the organic electrolyte layer and the second conductive layer has flexibility.

7. The thermoelectric module according to any one of claims 1 to 6,
wherein, when not heated, the thermoelectric unit has a two part structure of a conductive part and an insulating part, the conductive part including the first conductive layer and the second conductive layer, and the insulating part including the thermoelectric conversion layer and the organic electrolyte layer.

8. The thermoelectric module according to any one of claims 1 to 7, further comprising:
a first current collector including a conductive organic material and located at one end in a stacking direction of the first conductive layer, the thermoelectric conversion layer, the organic electrolyte layer and the second conductive layer; and
a second current collector including a metal located at the other end in the stacking direction.

9. The thermoelectric module according to any one of claims 1 to 7, further comprising:
a first current collector located at one end in a stacking direction of the first conductive layer, the thermoelectric conversion layer, the organic electrolyte layer and the second conductive layer; and
a second current collector located at the other end in the stacking direction,
wherein the first current collector includes the first conductive layer, the second conductive layer and a third conductive layer including a metal, and
wherein the second conductive layer is located between the first conductive layer and the third conductive layer in the stacking direction.

10. A method of manufacturing a thermoelectric module, comprising:
a first step of forming an electron transport layer on a first main face of a first conductive layer including a metal;
a second step of forming an electron thermal excitation layer on the electron transport layer;
a third step of forming a second conductive layer on a second main face of the first conductive layer; and
a fourth step of forming an organic electrolyte layer on the electron thermal excitation layer.

11. The method of manufacturing a thermoelectric module according to claim 10,
wherein, in the third step, the second conductive layer including a conductive organic material is formed.

12. The method of manufacturing a thermoelectric module according to claim 10 or 11, further comprising stacking thermoelectric units each other, each of the thermoelectric units including the first conductive layer, the electron transport layer, the electron thermal excitation layer, the organic electrolyte layer and the second conductive layer.

13. The method of manufacturing a thermoelectric module according to any one of claims 10 to 12,
wherein, in the third step, heat drying is performed, and
wherein vacuum drying is performed in the fourth step following the third step.

14. The method of manufacturing a thermoelectric module according to any one of claims 10 to 13, further comprising forming a first current collector,
wherein the first current collector includes the first conductive layer, the second conductive layer and a third conductive layer including a metal, and
wherein the second conductive layer is located between the first conductive layer and the third conductive layer in a stacking direction of the first conductive layer and the second conductive layer.

15. The method of manufacturing a thermoelectric module according to any one of claims 10 to 14, further comprising bringing a second current collector into contact with the organic electrolyte layer,
wherein the second current collector includes an organic conductive layer in contact with the organic electrolyte layer.
